# EUROPÄISCHE PATENTANMELDUNG

(11) **EP 0 740 497 A1**
(43) Veröffentlichungstag der Anmeldung: **30.10.1996**
(21) Anmeldenummer: 96810156.8
(22) Anmeldetag: 14.03.1996
(51) Int. Cl.: H05K 3/42, H05K 3/40

(54) **Elektrisches Verbindungssubstrat**

(30) Priorität: 24.04.1995 CH 1166/95
(71) Anmelder: DYCONEX PATENTE AG, 6300 Zug (CH); Hewlett-Packard GmbH, D-71034 Böblingen (DE)
(72) Erfinder: Schmidt, Walter, 8050 Zürich (CH); Dippon, Siegfried, 75391 Gechingen (DE)
(74) Vertreter: Frei, Alexandra Sarah

(57) **Zusammenfassung**

Die Erfindung betrifft mehrlagige Leiterplatten oder Folienleiterplatten und Verfahren zum Herstellen derselben, wobei die Leiterplatten oder Folienleiterplatten aus alternierend angeordneten Leit/Isolatorschichten. mit Durchleitungen (4,14) von Leitschichten (1) zu weiteren Leitschichten (2) durch diese elektrisch isolierende intermediäre Isolatorschichten (3) bestehen und in den Leitschichten (1,2) photochemisch strukturierten XY-Leiter (4.1,4.2,14.1, 14.2,14.3,14.5) und in schrägen oder senkrechten Oberflächen (4') von Öffnungen (4*) in Isolatorschichten (3) photochemisch strukturierte Durchleitungsleiter (4.4,14.4,14.14,14.24) verlaufen, derart, dass mindestens ein XY-Leiter (4.1,14,3) einer Leitschicht (1) an eine Durchleitung (4,14) mündet, dass jeder dieser XY-Leiter (4.1,14.3) über Durchleitungsleiter (4.4,14.4) mit jeweils mindestens einem XY-Leiter (4.2,14.5) der weiteren Leitschicht (2) elektrisch verbunden sein kann.

## Beschreibung

Die Erfindung bezieht sich auf elektrische Verbindungssunbstrate wie Leiterplatten, Multi-Chip-Modul (MCM)-Substrate mit Durchplattierungen.

In herkömmlichen Methoden der Leiterplattentechnik werden Platinenlöcher, welche primär zum elektrischen Verbinden verschiedener Leiterlagen verwendet werden, durch mechanisches Bohren erzeugt. Hierzu werden mehrlagige Leiterplatten oder Leiterfolien, bestehend aus mehreren Lagen von Metall/Isolatorschichten benutzt. Die Bohrlöcher werden dann mit elektrisch leitenden Materialien, beispielsweise Kupfer an ihren Innenseiten belegt oder ganz ausgefüllt, wodurch zwischen den einzelnen Leiterschichten (in Z-Richtung) elektrische Querverbindungen, sogenannte Durchkontaktierungen entstehen. Durch eine photochemische Strukturierung der Leiterebenen (in XY-Richtung), beispielsweise durch gezieltes Entfernen einzelner Oberflächenbereiche der äusseren Metallschichten einer Leiterplatten, können die entsprechenden Leiterverbindungen in XY-Richtung erzeugt werden. In der Kombination der flächig verlaufenden elektrischen XY-Leiter und der in Z-Richtung verlaufenden Durchkontaktierungen entsteht eine mehrlagige Leiterstruktur.

Ein Nachteil der konventionellen Technologie ist das mechanische Bohren der in Z-Richtung verlaufenden Löcher. Dieser Prozess stellt eine technologische Grenze der Leiterplattentechnik dar, da die Bohrdurchmesser bei etwa 0,2mm ihre natürliche Grenze finden. Bei kleineren Durchmessern sinkt die Ausbeute bedingt durch dass Brechen der Bohrer so stark ab, dass sich ein Einsatz aus Kostengründen verbietet. Zudem muss aus Toleranzgründen jedes Bohrloch mit sogenannten Lötaugen (pad) umgeben sein. Dieses Lötauge ist üblicherweise ca. 0,4 bis 0,5 mm grösser im Durchmesser als das entsprechende zugehörige Loch. Derartige Lötaugen verunmöglichen durch ihre flächige Ausdehnung eine optimale dichteste Strompfadbelegung. Aus diesem Grund ist man bei zunehmender Lochdichte moderner elektrischer Schaltungen gezwungen mehr und mehr zusätzliche Leiterebenen einzuzufügen, da die Verbindungsdichte pro Leiterebene durch zunehmede Lochdichte sinkt. Mehr Leiterebenen bedeutet jedoch neben höheren Kosten auch ein Anstieg der Gesamtdicke der Leiterplatten, was das Bohren kleiner Löcher weiter erschwert.

Da die Leiterzüge um die Löcher bzw. um deren Lötaugen herumgeführt werden müssen, steigt zudem auch die notwendige mittlere Leiterlänge an und dies hat negative Auswirkungen auf die Signalausbreitung bei hochfrequenten Anwendungen der elektrischen Schaltung führen.

Das Ätzen von Platinenlöchern in Leiterplatten und Folienleiterplatten bietet sich hier als Lösung an. Mittels Ätzen, beispielsweise mittels Plasma-Ätzen oder chemisches Ätzen lassen sich Öffnungen in Isolatorschichten mit verschiedensten Mündungsformen und mit sehr kleinen Durchmessern bewerkstelligen. Die Anmelderin verweist hier auf Ihre Patentanmeldung WO93/26143. Öffnungen werden als Sacklöcher und als Durchgangslöcher, mit drei-, vier- und mehreckige, elliptische und kreisförmigen Mündungen hergestellt. Das Plasma-Ätzen und chemische Ätzen sind Prozesse, bei denen Öffnungen in Isolatorschichten gemäss Öffnungen in Masken geätzt werden und bei denen die Isolatorschichten unterhalb der Öffnungsränder der Masken unterätzt werden. Je tiefer Isolatorschichten geätzt werden, desto stärker ist die Unterätzung ausgeprägt.

Ein Nachteil der Ätz-Verfahren besteht darin, dass solch unterätzten Maskenbereiche bei anschliessenden galvanischen Durchkontaktierungen dieser Öffnungen Probleme verursachen, indem die abgeschirmten Bereiche bspw. nur schlecht oder unzureichend mit elektrisch leitfähigem Material bedeckt werden. Diese Unterätzung lässt sich durch nachträgliches Entfernen solcher hinterätzter Maskenbereiche beheben. Die Anmelderin verweist hier auf Ihre Patentanmeldung CH 00505/94-0, wo überstehende Maskenbereiche an Öffnungen chemisch weggeätzt werden.

Ein solches nachträgliches Entfernen hinterätzer Maskenbereiche hat zur Folge, dass der Mündungsdurchmesser der plasmageätzten Öffnungen um den Betrag der Unterätzung vergrössert wird. Es entstehen Durchgangslöcher oder Sacklöcher mit zur Mündung hin sich erweiternden Lochwänden, die ungenutzte Oberflächenbereiche darstellen. Diese Öffnungen lassen sich zu Lötaugen aufplattieren, die aber wegen der grossen Mündungsdurchmesser, grossflächig sind. Diese Durchgangs- und Sacklöcher, sowie diese Lötaugen sind einer optimalen und dichtesten Strompfadbelegung der Leiterplatten nachteilig, da grössere Oberflächenbereiche der Leiterplatten ungenutzt verbleiben.

Es ist Aufgabe der vorliegenden Erfindung, Leiterplatten und Folienleiterplatten mit Durchplattierungen von Strompfaden und mit Kontaktstellen für elektrische Bauelemente sowie ein Verfahren zur Herstellung derselben aufzuzeigen, welche gemäss einem Layout optimal realisierte Durchkontaktierungen und Kontaktstellen aufweisen, ohne dass Oberflächenbereiche der Leiterplatten und Folienleiterplatten verfahrenstechnisch bedingt, ungenutzt bleiben. Dieses Verfahren soll mit gängigen und bewährten Techniken der Leiterplattentechnik, wie beispielsweise Ätzen oder galvanisches Abscheiden, realisiert werden.

Diese Aufgabe wird durch die Erfindung gemäss den Patentansprüchen gelöst.

Die Erfindung besteht grob gesagt darin, den Platzverbrauch von Durchplattierungen von Strompfaden und denjenigen von Kontaktstellen für Bauelemente durch eine vollständige Nutzung der Oberflächenbereiche der Leiterplatten und Folienleiterplatten zu verringern. Diese erfolgt durch die Strukturierung von schrägen und senkrechten Oberflächen in Öffungen der Leiterplatten und Folienleiterplatten. Es werden nicht nur, wie dem Fachmann bekannt, ebene Oberflächen der Leiterplatten und Folienleiterplatten für photochemische Strukturierungen von Leitern genutzt, sondern es werden zusätzlich und gleichzeitig hierzu auch schräge und senkrechte Oberflächen der Leiterplatten und Folienleiterplatten in Durchleitungsleiter strukturiert.

Dadurch dass die schrägen oder senkrechten Oberflächen oder Wandungen der Öffnungen photostrukturiert werden, sind die bisher notwendigen Lötaugen eliminierbar, sodass alle Oberfläche des Substrates zu einer optimalen Leiterführung nutzbar sind. Dies führt zu einer um den Faktor 2 bis 3 höheren Leiterzugdichte/Leiterebene bzw. zu einer Reduktion der notwendigen Anzahl Leiterebenen einer Leiterplatte oder Folienleiterplatte und zu eier Erhöhung der möglichen Packungsdichte der elektronischen Komponenten weiter an. Die in die kraterähnlichen Lochränder hineinlaufenden Signalleiter weisen keine Lötaugen mehr auf und daher werden schnelle Signale nicht mehr reflektiert. Dies ist gerade bei hochfrequenten Anwendungen sehr vorteilhaft.

Dadurch dass die schrägen oder senkrechten Oberflächen oder Wandungen der Öffnungen photostrukturiert werden, skönnen auch mehrere unterschiedliche Signalleiter durch eine Öffnung (Z-Leiter) geführt werden, was einen weiteren Platzgewinn und eine entsprechend höhere Packungsdichte erlaubt.

Dadurch dass mehrere Leiter einer Leiterebene (XY-Leiter) an eine der Öffnungen von Isolatorschichten heranführbar sind, sind diese elektrischen Schaltungen nachkontaktierbar. Anstatt beispielsweise für fünf unterschiedliche mögliche elektrische Schaltungen auf einer Universalplatine fünf verschiedene Durchplattierungen parallel anzulegen, ist dies mit einer Durchleitung von fünf Z-Leitern möglich.

Beim erfindungsgemässen Verfahren wird neben der Leitschicht der XY-Ebenen auch die leitschichtbedeckte Lochwandung photochemisch strukturiert. Dies ist aufgrund des günstigen Längenverhältnisses vom Durchmesser der Öffnungen zur Dicke der Öffnungen möglich. Wenn die Lochwandung nicht exakt zylindrisch ist, sondern beispielsweise kegelförmig, so wird die Lochwandung einer Belichtung über Photomasken zugänglich. Die Öffnungen können entweder als Durchgangslöcher ausgeführt sein, bei denen sich zwei Kegel von beiden Seiten der Leiterplatte oder Folienleiterplatte her bilden, oder sie können als Sacklöcher ausgeführt sein, bei denen naturgemäss nur ein kegelförmiger Trichter ausgebildet wird. Im ersten Fall erfolgt die Belichtung einer Öffnung von beiden Seiten her, im zweiten Fall erfolgt die Belichtung einer Öffnung von einer Seite her.

Die Bildung der beispielsweise kegelförmigen Lochwandung kann durch isotropes Ätzen mittels Plasma oder auch durch ein ganz oder teilweise isotropes chmisches Ätzen (nasschemisches Verfahren) erzeugt werden. Des weiteren ist bekannt, dass kegelförmige Löcher auch mittels Laser erzeugt werden können. In Grenzfällen lassen sich kegelförmige Sacklöcher auch durch mechanisches Bohren erzeugen. Die Form der Mündungen der Durchleitungen ist frei strukturierbar und kann mehreckig mit geraden Kanten sein, sodass die herangeführten XY-Leiter einer Ebene durch Kanten voneinander getrennt sind, oder sie kann kreiszylindrisch oder oval sein, mit runden Kanten. Beispielsweise kegelförmige Öffnungen in Form von Durchgangslöchern können um ihre Kegelachse versetzt sein. Im Sinne eines vorteilhaften, dichtesten flächendeckenden Leitermusters ist eine mehreckige Mündung zu favorisieren. Hieraus ergeben sich neue Freiheitsgrade im Design von Leiterplatten, Leiterfolien oder anderen Substraten. Die Kontaktstellen in Öffnungen erlauben eine optimale Leitergeometrie der XY-Leiter auf ebenen Oberflächen für hochfrequente Anwendungen. Die XY-Leiter lassen sich im konstanten und minimalen Abstand zueinander an Öffnungen heran und an ihnen verbeiführen, sodass unerwünschte Reflexionen und Signalstörungen vermieden werden.

Anhand der nachfolgend aufgeführten Figuren 1 bis 8 wird das erfindungsgemässe Verfahren näher erläutert.
- Fig. 1a-1i: zeigen in perspektivischer Ansicht ein bekanntes Verfahren zur Herstellung einer typischen Durchplattierung in Form eines Sackloches mit einem Lötauge.
- Fig. 2a-2f: zeigen ein erfindungsgemässes Verfahren zur Herstellung einer Durchleitung in der Ausführung eines Teils einer kreiszylindrischen Vierfach-Durchleitung im Querschnitt.
- Fig. 3a-3f: zeigen ein erfindungsgemässes Verfahren zur Herstellung einer Durchleitung in der Ausführung eines Teils einer kreiszylindrischen Vierfach-Durchleitung in einem Zweiachsenschnitt.
- Fig.4: zeigt die Ausführungsform eines Teils einer kreiszylindrischen Vierfach-Durchleitung gemäss den Figuren 2f und 3f in einer beispielhaften perspektivischen Ansicht.
- Fig. 5a-5d: zeigen vier weitere Ausführungsformen von Teilen erfindungsgemässer Durchleitung.
- Fig. 6a-6i: zeigen in perspektivischer Ansicht ein erfindungsgemässes Verfahren zur Herstellung einer erfindungsgemässen Durchleitung in der Ausführungsform eines Sackloches mit Kontaktstelle.
- Fig. 7a-7h: zeigen in einem Querschnitt senkrecht zu den XY-Leitern gemäss den Figuren 6a bis 6i ein erfindungsgemässes Verfahren zur Herstellung einer erfindungsgemässen Durchleitung in der Ausführungsform eines Sackloches mit Kontaktstelle.
- Fig. 8a-8h: zeigen in einem Querschnitt parallel zu den XY-Leitern gemäss den Figuren 6a bis 6h ein erfindungsgemässes Verfahren zur Herstellung einer erfindungsgemässen Durchleitung in der Ausführungsform eines Sackloches mit Kontakstelle.
- Fig. 9a-9b: zeigen eine perspektivische Ansicht und eine Draufsuicht einer im erfindungsgemässen Verfahren hergestellten Durchleitung in der Ausführungsform eines Sackloches mit Kontaktstelle.

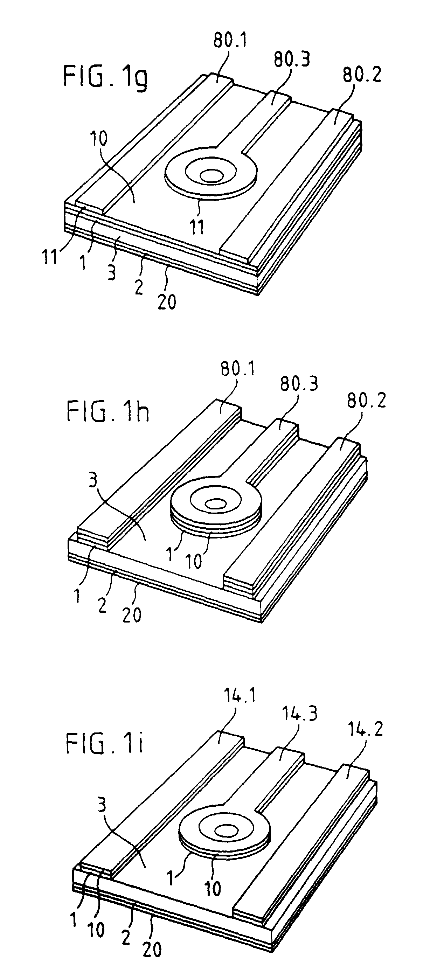

Die **Figuren 1a bis 1i** zeigen in perspektivischer Ansicht ein bekanntes Verfahren zur Herstellung einer beispielhaften Durchplattierung mit Kontaktstelle in Leiterplatten oder Folienleiterplatten in Form eines Sackloches mit einem Lötauge. Hierfür wird ein zweilagiges Vorfabrikat für eine mehrlagigen Leiterplatte oder Folienleiterplatte verwendet, das bspw. aus einer Metallschicht 1 aus Kupfer oder anderen gebräuchlichen Leitermaterialien wie Aluminium, Silber, etc. besteht und das aus einer Isolatorschicht 3 aus Polyimid oder anderen gebräuchlichen Isolatormaterialien wie aramidfaserverstärkte Laminate aus Epoxyd- Polyimid- oder Zyanat-Ester-Harzfolien oder Liquid Crystal Polymers (LPC) besteht.

In die Metallschicht 1 wird, bspw. mittels photochemischer Strukturierung, eine vorbereitete Öffnung eingebracht (siehe **Figur 1a**). Die Metallschicht 1 dient daraufhin als Maske für das Einbringen einer Öffnung im Isolatormaterial 3. Entsprechend der Position und Formgebung dieser Maske wird gemäss **Figur 1b**, beispielsweise durch Plasma-Ätzen, eine Hinterätzung in der Isolatorschicht 3 vorgenommen. Der unterätzte Maskenbereich um die Mündung der Öffnung wird gemäss **Figur 1c** entfernt. Dies erfolgt beispielsweise im von der Anmelderin in der Patentanmeldung CH 00505/94-0 offenbarten Verfahren, wo überstehende Maskenbereiche chemisch weggeätzt werden. Die Öffnung im Vorfabrikat wird somit um diesen unterätzen Bereich der Maske zu einer Öffnung 4* mit schrägen Wandbereichen vergrössert. Diese Öffnung 4* ersteckt sich konisch oder kugelförmig ins Innere der Isolatorschicht 3. Auf der Unterseite des Vorfabrikates wird eine weitere Metallschicht 2, bspw. aus Kupfer, Aluminium, Silber, etc. aufgebracht, sodass die Öffnung 4* im Vorfabrikat zu einem Sackloch wird, welches in Folge des Plasma-Ätz-Verfahrens schräge Wände in der Isolatorschicht 3 aufweist, die sich zur Mündung in der Metallschicht 1 hin, erweitern.

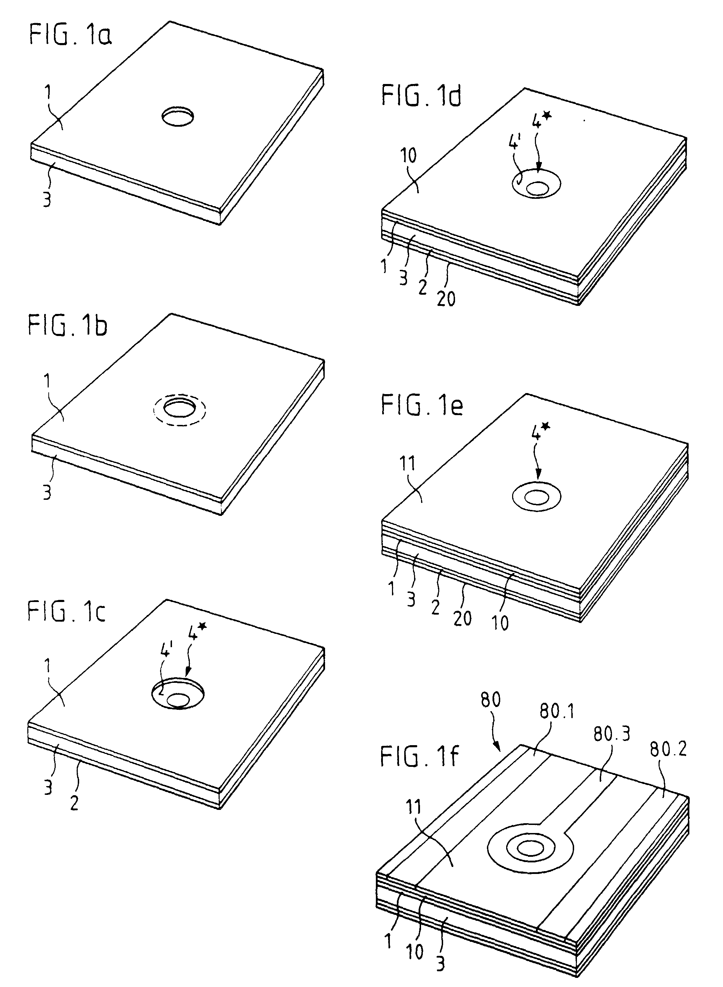

Gemäss **Figur 1d** werden alle zugänglichen Oberflächenbereiche des Vorfabrikates, d.h. die Metallschichten 1 und 2, sowie die Bereiche der Öffnung 4* im Isolatormaterial 2 mit elektrisch leitfähigen Schichten 10 und 20 beispielsweise mit Kupfer, Gold, Nickel, Platin, Aluminium etc. galvanisch aufplattiert. Die das Sackloch vollständig bedeckende elektrisch leitfähige Schicht 10 wird mit einer Schicht beispielsweise flüssigen Photoresist 11 vollständig bedeckt (siehe **Figur 1e**). Der Photoresist wird in einen Schaltungsentwurf 80 belichtet (siehe **Figur 1f**). Im Inneren und um die Öffnung 4* herum und ist ein Entwurf für ein Sackloch mit Lötauge und für einen zuführenden Leiter 80.3 angelegt. Beidseitig dieses Sacklochentwurfes und des zuführenden Leiterentwurfes 80.3 verlaufen Strompfadentwürfe 80.1,80.2 in einem Sicherheitsabstand zur Lötstellenumgrenzung.

Gemäss **Figur 1g** werden unbelichtete Oberflächenbereiche Photoresist 11 bis auf die Metallschicht 10 herab entfernt. In der Metallschicht 10 werden gemäss dem Schaltungsentwurf 80 die Leiter und das Lötauge vorgebildet. Gemäss **Figur 1h** wird in Oberflächenbereichen, die nicht mit strukturietem Photoresist 11 bedeckt sind, Metall der Metallschicht 10 bis auf die Isolatorschicht 30 herab, beispielsweise nasschemisch, weggeätzt. Das restliche Photoresist 11 wird daraufhin entfernt (siehe **Figur 1i**). Hierdurch werden Leiter 14.1,14.2,14.3 und eine Durchplattierung in Form eines Sackloches mit Lötauge gebildet. Diese Durchplattierung verbindet die beiden elektrisch leitfähigen Ebenen 1 und 2 des Vorproduktes und ist zur mechanischen Verstärkung mit der Metallschicht 10 aufplattiert. Diese Durchplattierung weist zur Mündung hin sich erweiternde Lochwände auf und besitzt aufgrund des grossen Mündungsdurchmessers eine dementsprechend grosse flächige Ausdehnung. Der minimal notwendige Abstand der elektrischen Oberflächenstrukturierierungen, d.h. der minimale Abstand zwischen Leiterbahnen 14.1,14.2,14.3 wird durch die nicht vergleichbaren Formen des runden Lötauges mit den länglichen Leitern beschränkt. Die Leiter 14.1,14.2,14.3 sind lediglich im Bereich des Lötauges minimal eng geführt, in anderen Bereichen weisen sie einen unnötig grossen Abstand zueinander auf. Eine solche grossflächige Ausdehnung des Lötauges ist für eine optimale und dichteste Strompfadbelegung nachteilig. Grössere Oberflächenbereiche der Leiterplatten oder Folienleiterplatten verbleiben ungenutzt. Entgegen einer optimalen Realisierung eines Layoutes in einer optimalen elektrischen Schaltung, werden Leiter in der obigen Beispielausführung lediglich an derart grossflächigen Lötaugen minimal nahe verbeigeführt, in anderen Oberflächenbereichen werden sie im nicht minimalen, zu weiten Abstand zueinander geführt. In anderen, nicht gezeigten Beispielausführungen von Schaltungen werden solche Leiter auch um Lötaugen herumgeführt, was ebenfalls nicht im Sinn einer optimalen Platzausnutzung und einer optimalen Realisierung eines Layoutes ist. Schliesslich ist es wichtig zu erwähnen, dass örtlich varierende gegenseitige Abstände der Leiter und des Lötauges, Abweichungen von der optimalen Leitergeometrie bilden, wie sie insbesondere bei hochfrequenten Anwendungen von elektrischen Schaltung notwendig sind, und dass diese Abweichungen von einer optimalen Leitergeometrie, zu unerwünschten Reflexionen und Signalstörungen führen.

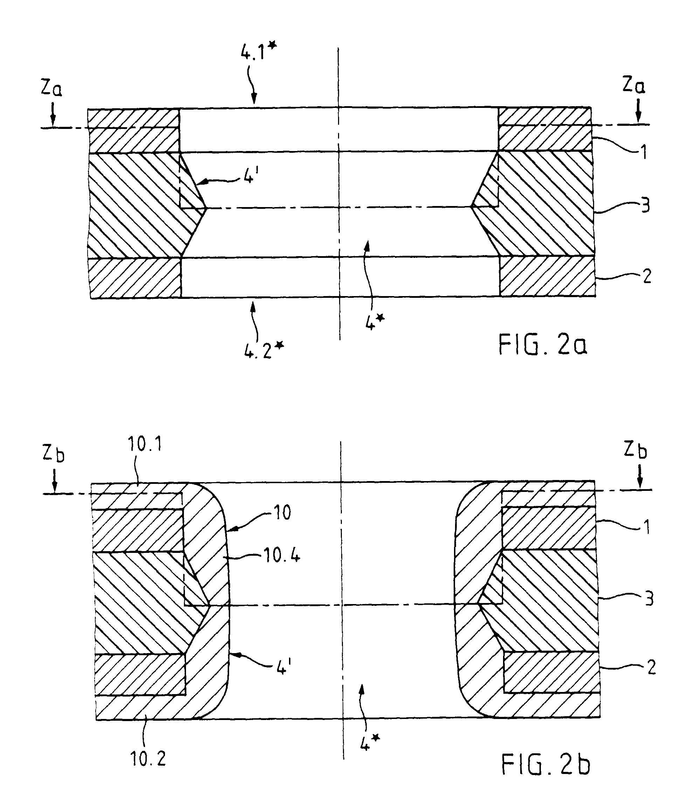

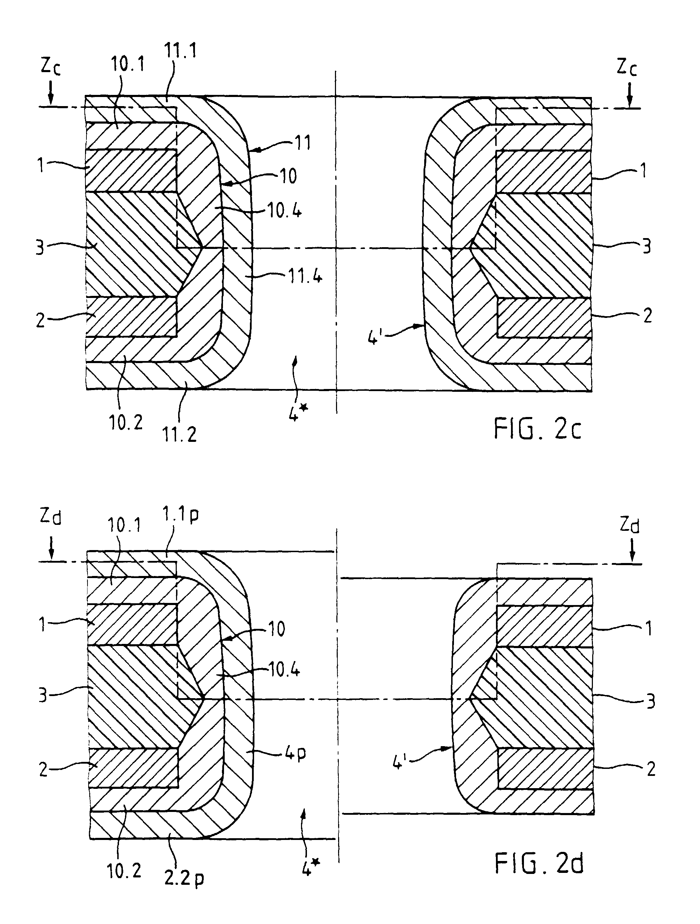

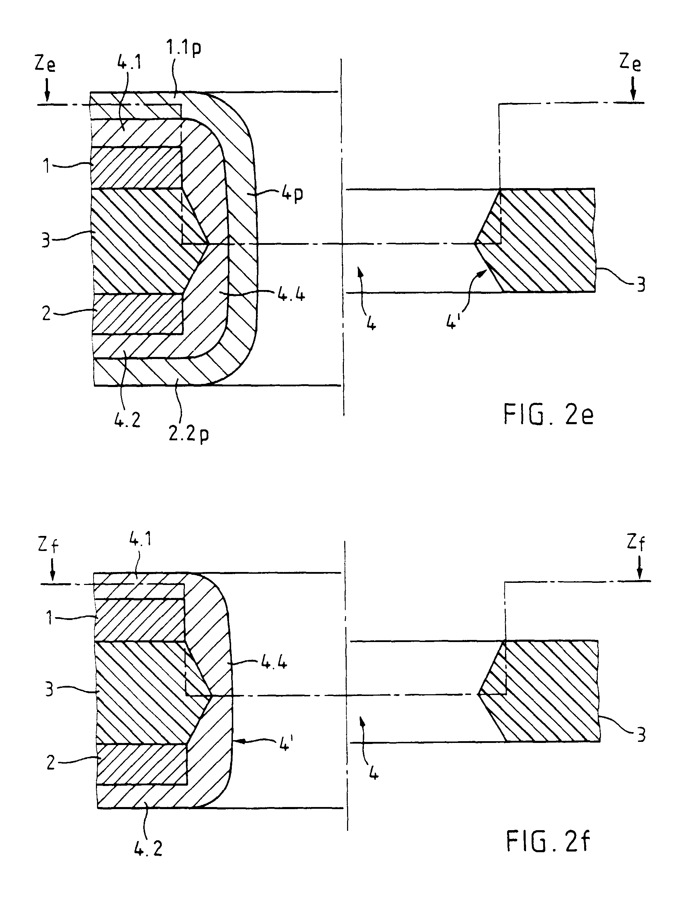

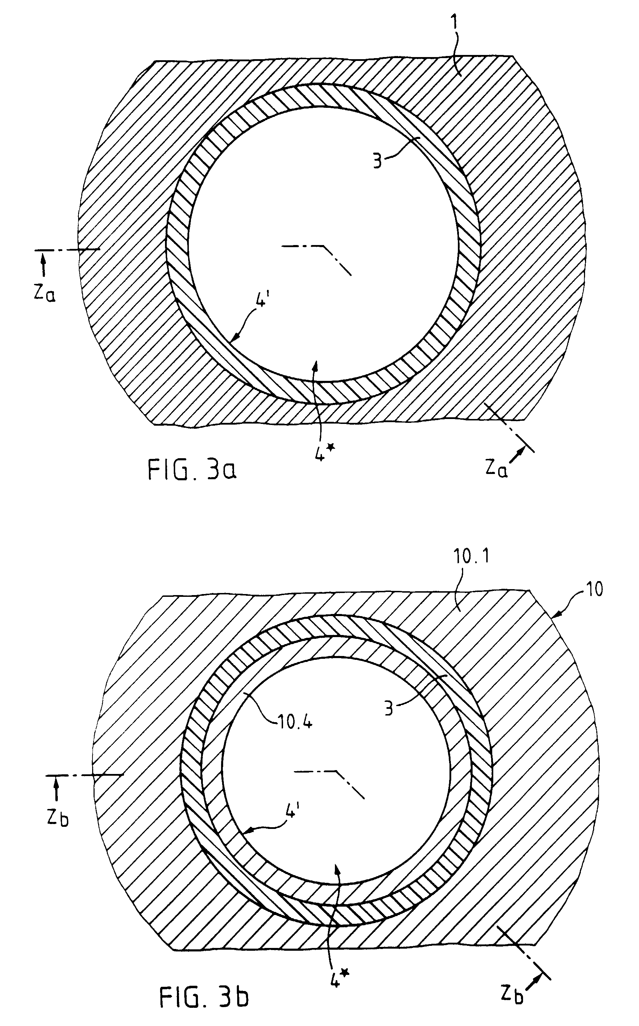

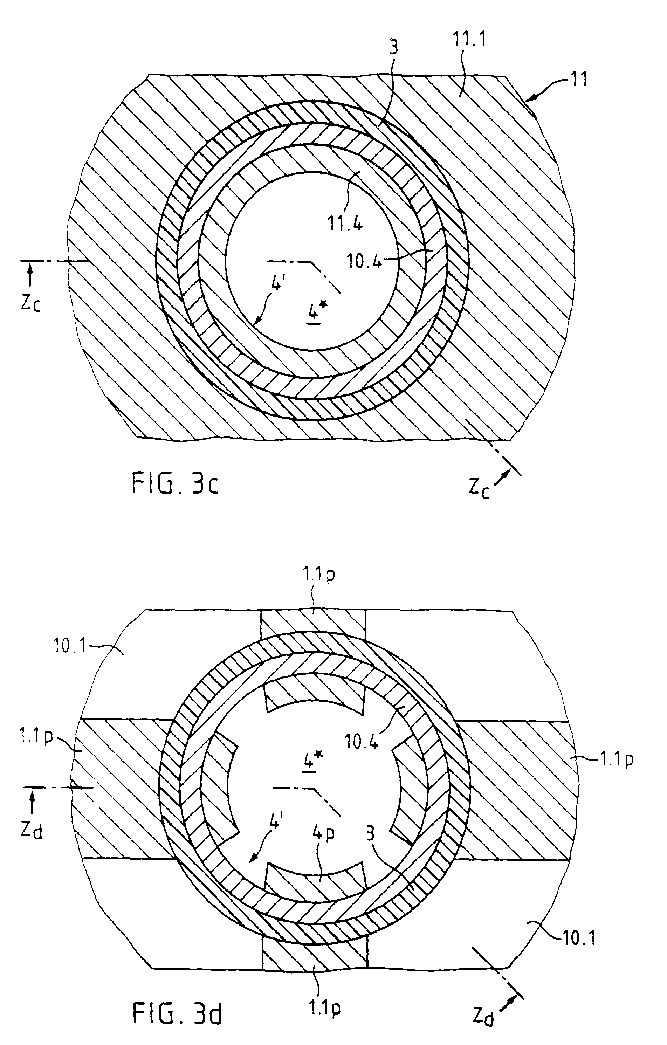

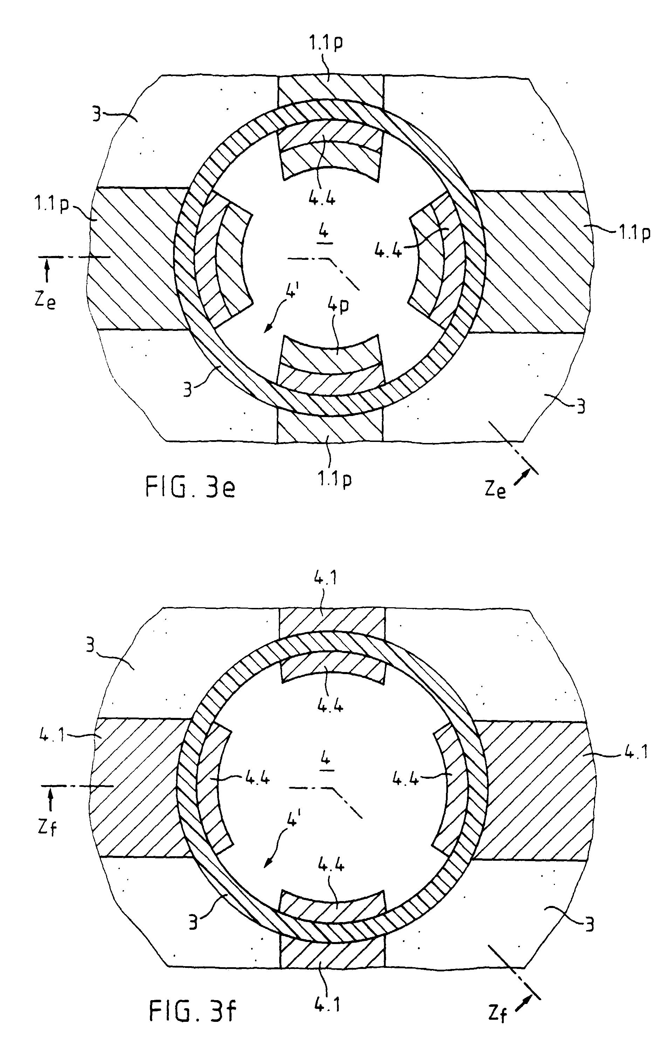

In den **Figuren 2** und **3** ist ein erfindungsgemässe Verfahren zur Herstellung einer Durchleitung 4 in einer ersten Ausführungsform eines Teils einer kreiszylindrischen Vierfach-Durchleitung in Form eines Durchgangsloches zu sehen. Hierfür wird ein zweilagiges Vorfabrikat einer mehrlagigen Leiterplatte oder Folienleiterplatte verwendet wie in der Beschreibung gemäss den Figuren la bis li beschrieben, so dass auf diese Beschreibung verwiesen wird und dies hier nicht wiederholt wird.

**Figur 2a** und **Figur 3a** zeigen einen Teil eines Vorfabrikates des erfindungsgemässen Verfahrens in der Ausführungsform einer zweilagigen Leiterfolie mit einer Öffnung 4*. Es werden bevorzugt elektrisch leitende Schichten 1, 2 und Isolatorschichten 3 von 10 bis 50 µm Dicke verwendet. Die Öffnung 4* weist in dieser Ausführungsform eine kreisförmige Geometrie auf und hat einen kleinen Durchmesser von 10 bis 100 µm. Sie weist Mündungen 4.1*, 4.2*, mit runden Kanten auf. Der Schnitt Zₐ erfolgt entlang eines Teils der Metallschicht 1, der Isolatorschicht 3 und der Öffnung 4*. Die Oberfläche 4' der Öffnung 4* hingegen ist aufgrund des beispielsweise verwendeten Plasma-Ätz-Prozesses schräg, d.h. die Mündungsbereiche der Öffnung 4* weisen einen grösseren Durchmesser als die Innenbereiche auf. Die Metallschichten 1,2 sind durch eine Isolatorschicht 3 elektrisch voneinander getrennt.

In **Figur 2b** und **Figur 3b** sieht man wie auf das Vorfabrikat gemäss den Figuren 2a und 3a eine Metallschicht 10 beispielsweise durch galvanisches Abscheiden aufplattiert wird. Der Schnitt Z_{b} erfolgt entlang eines Teils der Metallschichten 10, 1 der Isolatorschicht 3 und der Öffnung 4*. Die Metallschicht 10 umschliesst das Vorfabrikat vollständig, d.h. sie bedeckt die Metallschichten 1,2 und die Oberfläche 4' der Öffnung 4* mit einer elektrisch leitenden Metllschicht. Im Bereich der Öffnung 4* wird dies als Metallschicht 10.4 bezeichnet, Im Bereich der Metallschichten 1,2 wird sie Metallschicht 10.1,10.2 genannt. Die Metallschichten 10.1,10.4,10.2, 10.4 grenzen nahtlos aneinander.

In **Figur 2c** und **Figur 3c** sieht man dieses beschichtete Vorfabrikat gemäss den Figuren 2b und 3b nach dem Auftragen einer Photoresistschicht 11 auf die Metallschicht 10. Der Schnitt Z_{c} erfolgt entlang eines Teils der Photoresistschicht 11, der Metallschichten 10,1, der Isolatorschicht 3 und der Öffnung 4*. Die Metallschicht 10 ist vollständig mit Photoresisit bedeckt. Im Bereich der Öffnung 4* wird dies als Photoresistschicht 11.4 bezeichnet. Im Bereich der Metallschichten 10.1,10.2 wird sie Photoresistschicht 11.1,11.2 genannt. Die Photoresistschichten 11.1,11.4 sowie 11.2,11.4 grenzen nahtlos aneinander an. Es kann festes oder flüssiges Photoresist verwendet werden. Das Photoresist kann die Öffnung 4* auch vollständig ausfüllen.

In **Figur 2d** und **Figur 3d** sieht man eine photochemisch durchgeführte Strukturierung der Schicht Photoresist 11. Der Schnitt Z_{d} erfolgt entlang eines Teils der strukturierten Photoresistschicht 11, der Metallschichten 1,10, der Isolatorschicht 3 und der Öffnung 4*. Die strukturierte Schicht Photoresist 11.4 besteht nun aus frei wählbaren Z-Leiterstrukturen 4p, welche bis auf die metallischen Schicht 10 herabreichen. Die strukturierten Schichten Photoresist 11.1, 11.2 bestehen jetzt aus frei wählbaren XY-Leiterstrukturen 1.1p,2.2p, welche bis auf die metallischen Schichten 10.1,10.2 herabreichen. In den Bereichen, wo sich Photoresist befindet, wird in den folgenden Verfahrensschritten kein Leitmaterial entfernt.

Diese Strukturierung der schrägen oder senkrechten Oberfläche der Öffnung 4* in Form eines Durchgangsloches ist nur aufgrund der gewählte Längenverhältnisse L=Dₘ/dₘ für die Dimensionen der Öffnung 4* und der Dicke der Leiterfolie möglich. Mit Dₘ wird der minimaler Durchmesser der Öffnung 4* nach Auftragung der Leitschicht 10 und der Schicht Photoresisit 11 bezeichnet, mit dₘ wird die maximale Dicke der Leiterfolie nach Auftragung der Schichten Leitmaterial 10 und Photoresist 11 bezeichnet. Die Z-Leiterstrukturen lassen sich also problemlos generieren, wenn der minimale Durchmesser Dₘ und die maximale Dicke dₘ einem günstigen Längenverhältnis L∼1 und die gleiche Grössenordnung aufweisen. Dies hat Auswirkungen. Für dicke Leiterplatten muss der Durchmesser der Öffnungen 4* dementsprechend vergrössert werden. D.h. für eine 1 mm dicke Leiterplatte müssen die Öffnung 4* einen Durchmesser von 1 bis 2 mm aufweisen, um ein gleiches Längenverhältnis zu erhalten. Die Lochausführungen können sehr unterschiedlich sein. Insbesondere können Öffnungen 4* in Form von Durchgangslöcher mit zwei Lochöffnungen ausgebildet werden. Diese Lochöffnungen könne in Achse oder axial versetzt zueinander angebracht werden. Diese Lochöffnungen könen zudem konisch oder kugelförmig schräg ins Innere der Leiterplatte oder Folienleiterplatte verlaufen. Die Kegelgrösse der Lochöffnungen unterscheidlich sein können. Die Kegelachsen der kegelförmigen Durchgangslöcher zueinander versetzt sein. Der kleinste mögliche Kegelwinkel liegt je nach verwendetem Photoresist 11, je nach Belichtungsart und Längenverhältnis L zwischen 5° und 15°. Dem Fachmann stehen bei Kenntnis der vorliegenden Erfindung vielfältige Möglichkeiten der Variation solcher Geometrien und Masse zur Verfügung.

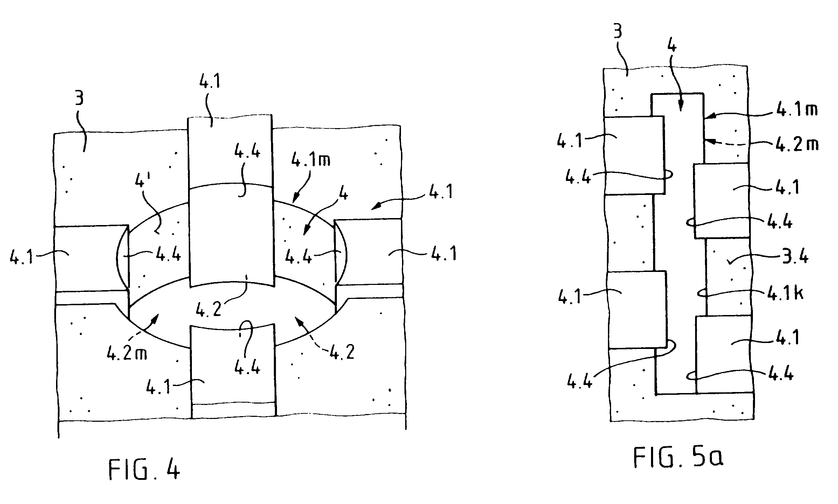

In **Figur 2e** und **Figur 3e** sieht man die gemäss Figur 2d und Figur 3d photochemisch strukturierte Leiterfolie nach erfolgtem nasschemischen Ätzen des von Photoresist unbedeckten Metalls der Metallschichten 10,1,2. Dieses Ätzen geschieht gemäss dem Schaltungsentwurf und führt zum gezielten Entfernen einzelner Bereiche der Metallschichten 10,1,2. Hierdurch werden Leiter in der Ebene der Schichten 1,2 oder XY-Leiter 4.1,4.2 und Durchleitungsleiter schräg bzw. senkrecht hierzu oder Z-Leiter 4.4 eines Leiterbildes erzeugt. Diese Durchplattierung wird als Durchleitung 4 bezeichnet. Das nasschemische Ätzen findet gezielt in der Tiefe statt, d.h. die metallschichten 10 sowie 1 und 2 werden in von Photoresist unbedeckten Bereichen bis auf die Isolatorschicht 3 herunter entfernt, derart, dass die XY-Leiter 4,1,4,2 und die Z-Leiter 4.4 durch die Isolatorschicht 3 gegeneinander isoliert sind. In dieser Ausführungsform werden auf beiden Seiten der Leiterfolie vier im Winkel von 90° zueinander versetzte XY-Leiter 4.1,4.2 an die Durchleitung 4 herangeführt und über vier Z-Leiter 4.4 miteinander elektrisch verbunden. Der Schnitt Zₑ in Figur 2e und Figur 3e erfolgt entlang eines Teils der Strompfadstrukturen 1.1p, der strukturierten Metallschichten 10,1, sowie der Isolatorschicht 3 und der Durchleitung 4. Auf der schrägen oder senkrechten Oberfläche 4' der Durchleitung 4 wird ein Leitermuster mit Z-Leitern 4.4 herausgeätzt. Dieses Ätzen der XY-Leiter 4.1,4.2 und der Z-Leiter 4.4 kann gleichzeitig in einem Verfahrensschritt geschehen. Diese erste Ausführungsform einer Durchleitung 4 ist in Figur 4 noch einmal in einer perspektivischen Ansicht auf die erste Stirnseite der Leiterfolie abgebildet.

In **Figur 2f** und **Figur 3f** sieht man die sich im Herstellungsstadium gemäss Figur 2e und Figur 3e befindliche Leiterfolie nach Entfernen der Schichten Photoresist 4p, 1.1p, 2.2p. Dieses erfindungsgemässe Herstellungsverfahren verwendet bevorzugterweise dünne Leiterfolien und ätzt kleine Öffnungen 4*, deren Längenverhältnisse L günstig gewählt wird, derart, dass eine photochemische Strukturierung von Z-Leitern 4.4 möglich ist. Durch die nach aussen, zu den Mündungen hin angeschrägten Innenflächen der Öffnungen 4*, wird eine Belichtung des Photoresistes begünstigt. Dies ist beispielsweise bei Verwendung von vollflächig abgeschiedenen Kupferhülsen in bekannten mechanisch gebohrten Löchern (Durchmesser 0,2 mm, Länge 1 mm) unmöglich, da - der Photoresist in solchen kleinen und langen Löchern mit ungünstigem Längenverhältnis L nicht belichtet werden kann, sodass keine Strukturierung auf den Innenflächen dieser Löcher vorgenommen werden kann.

In **Figur 4** sieht man einen Teil dieser ersten Ausführungsform einer Durchleitung 4 nach dem erfindungsgemässen Herstellungsverfahren gemäss den Figuren 2 und 3 noch einmal in einer perspektivischen Ansicht der ersten Stirnseite der Leiterfolie. In der strukturierten Metallschicht 1 verlaufen vier im Winkel von 90° zueinander angeordnete XY-Leiter 4.1, die durch eine Isolatorschicht 3 getragen werden und bis an die kreisförmige Mündung 4.1m der Durchleitung 4 heranreichen. Sie gehen hier nahtlos in vier im Winkel von 90° zueinander angeordnete Z-Leiter 4.4 der Oberfläche 4' der Öffnung über, die ebenfalls durch die Isolatorschicht 3 getragen werden. Am anderen Ende der Durchleitung 4, an der Mündung 4.2m, gehen die Z-Leiter 4.4 nahtlos in vier im Winkel von 90° zueinander angeordnete XY-Leiter 4.2 über, die auch durch die Isolatorschicht 3 getragen werden und elektrisch voneinander isoliert auf der weiteren strukturierten Metallschicht 2 der Leiterfolie verlaufen. Die letzteren sind in Figur 4 nur zum Teil zu sehen, in dieser ersten beispielhaften Ausführungsform verlaufen die XY-Leiter 4.1,4.2 in beiden strukturierten Metallschichten 1,2 gleich, sodass auch die Ansichten auf die strukturierten Metallschichten 1 und 2 gleich sind.

Diese direkte XY-Leiter 4.1 zu XY-Leiter 4.2 Verbindung über einen Z-Leiter 4.4 ist nicht zwingend. Dem Fachmann stehen bei Kenntnis dieser Erfindung eine grosse Anzahl möglicher Arten von Durchleitungen frei. So ist es möglich, beispielsweise zwei in einer strukturierten Metallschicht 1 gegeneinander elektrisch isolierte XY-Leiter 4.1 über zwei gegeneinander elektrisch isolierte Z-Leiter 4.4 durch eine Durchleitung 4 in eine weitere strukturierte Metallschicht 2 zu führen und dort in beispielsweise nur einem XY-Leiter 4.2 weiterzuführen. Auch ist es möglich, beispielsweise vier gegeneinander elektrisch isolierte XY-Leiter 4.1 einer strukturierten Metallschicht 1 über lediglich zwei Z-Leiter 4.4 durch eine Durchleitung 4 auf eine weitere strukturierte Metallschicht 2 und dort in beispielsweise zwei XY-Leiter 4.2 zu führen.

Diese Durchleitung 4 ermöglicht eine nachträgliche Konditionierung der Schaltungen durch mechanisches Durchtrennen von an die Durchleitung 4 herangeführten XY-Leitern 4.1,4.2. So kann eine Universal-Leiterfolie mit mehreren möglichen Schaltungen strukturiert werden und je nach gewünschter Schaltung, kann am Ende des Herstellungsverfahrens eine dieser Schaltungen in einer Konditionierung realisiert werden. Diese Konditionierung kann auch durch photochemisches Entfernen von XY-Leitern 4.1,4.2 und/oder Z-Leitern 4.4 geschehen.

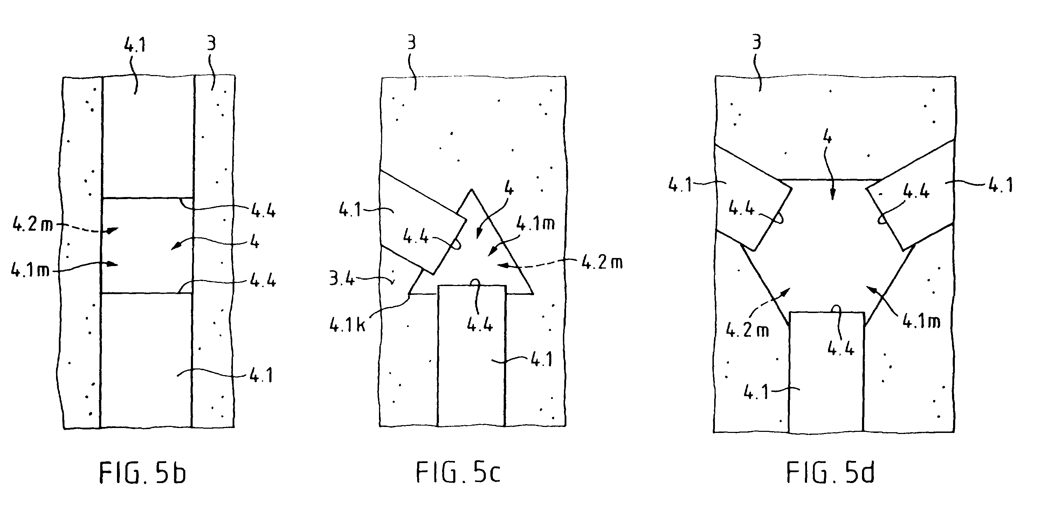

In **Figur 5** sind vier weitere Ausführungsformen von Teilen erfindungsgemässer Durchleitungen 4 in Form von Durchgangslöchern in Leiterplatten oder Folienleiterplatten zu sehen. Diese Durchleitungen 4 verbinden mindestens zwei XY-Leitern 4.1 aus strukturierten Metallschichten 1,2 über Z-Leiter 4.4. Die Geometrien der Mündungen 4.1m, 4.2m der Durchleitungen 4 können beispielsweise im Plasma-Ätz-Verfahren frei geformt werden und unterscheiden sich somit von runden Mündungen mechanisch gebohrter Durchplattierungen. Dies ermöglicht neue Möglichkeiten beim Entwurf der elektrischen Schaltungen.

In **Figur 5a** sieht man eine zweite Ausführungsform einer Durchleitung 4 mit einer rechteckigen Mündung 4.1, geraden Kanten und vier herangeführten XY-Leitern 4.1. In **Figur 5b** sieht man eine dritte Ausführungsform einer Durchleitung 4 mit einer quadratischen Mündung 4.1. geraden Kanten und zwei herangeführten XY-Leitern 4,1.In **Figur 5c** sieht man eine vierte Ausführungsform einer Durchleitung 4 mit einer dreickigen Mündung 4.1, geraden Kanten und zwei herangeführten XY-Leitern 4.1. In **Figur 5d** sieht man eine fünfte Ausführungsform einer Durchleitung 4 mit einer sechseckigen Mündung 4.1, geraden Kanten und drei herangeführten XY-Leitern 4.1.

Ein vorteilhaftes flächendeckendes Leitermuster erhält man bei Verwendung von Mündungen mit geraden Kanten oder geradkantigen Mündungen. Die in einer Ebene an eine Mündung 4.1m einer Durchleitung stossenden XY-Leiter 4.1 werden so durch die Ecken der Mündung 4.1m voneinander getrennt. Man benötigt somit keine isolierende Kante einer Mündung, um die in einer Ebene anstossenden XY-Leiter voneinander zu trennen. Dies ist beispielsweise bei der Mündung 4.1m der Durchleitung 4 in der Ausführungsform gemäss Figur 5a der Fall. Hier sind zwei XY-Leiter 4.1 lediglich durch eine Isolationsfläche 3.4 der Isolatorschicht 3 und eine isolierende Kante 4.1k der Mündung 4.1m voneinander getrennt. Da eine isolierende Kante einer Mündung notwendigerweise breiter sein muss, als die (isolierenden) Ecken geradkantiger Mündungen, führt die Verwendung von geradkantigen Mündungen so zu flächendekkenden Leitermustern mit optimaler und dichtester Strompfadbelegung. Dies ist beispielsweise bei der Mündung 4.1m der Durchleitung 4 in der Ausführungsform gemäss Figur 5c der Fall. Hier liegen zwei XY-Leiter 4.1 räumlich dichter beieinander, sie sind durch eine Isolationsfläche 3.4 der Isolatorschicht 3 und eine isolierende Ecke 4.1k voneinander getrennt, woraus eine dichtere Strompfadbelegung resultiert.

Mittels eines erfindungsgemässen Verfahrens lassen sich somit Leiterstrukturen für mehrere potentielle Schaltungen auf einer Leiterplatte erzeugen. Man erhält so die Möglichkeit einer nachträglichen Konditionierung dieser Leiterplatte über das Schliessen bestimmter elektrischer Verbindungen durch die Durchleitungen. Dies geschieht im einfachsten Fall durch mechanisches Durchtrennen oder durch photochemisches Entfernen gewisser überflüssiger, herangeführter XY-Leiter. Dem Fachmann stehen vielfältigste Anwendungen der vorliegenden Erfindung offen.

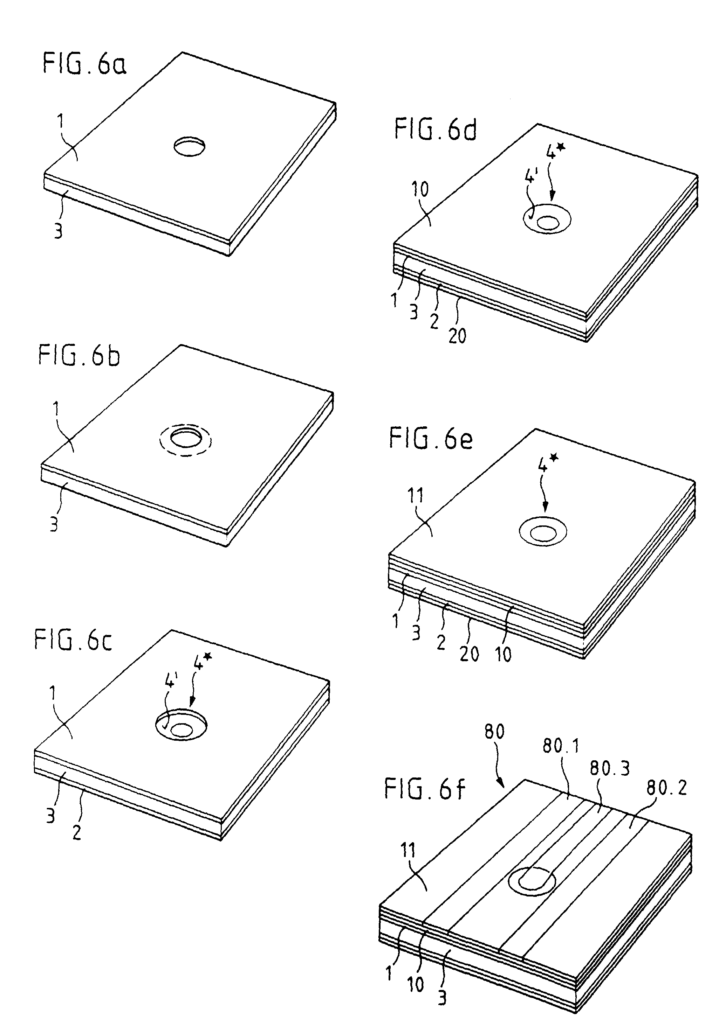

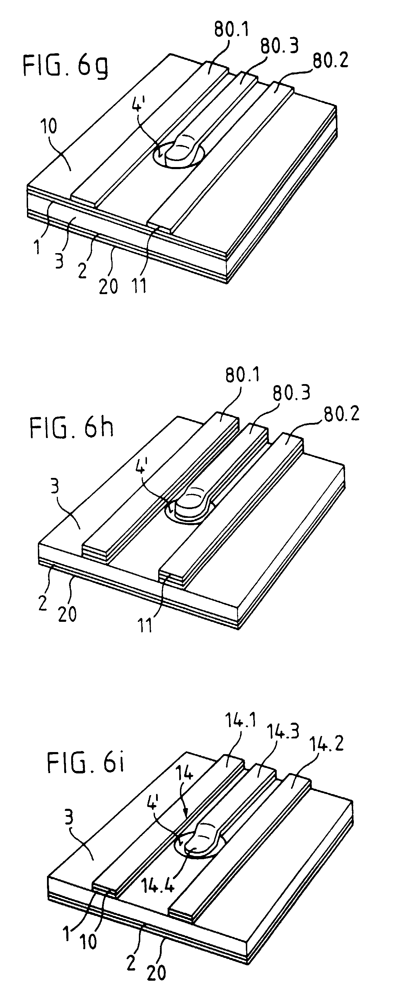

Die **Figuren 6a bis 6i** zeigen in perspektivischer Ansicht ein erfindungsgemässens Verfahren zur Herstellung einer Durchleitung mit Kontaktstelle in Leiterplatten oder Folienleiterplatten in Form eines Sackloches. Hierfür wird ein zweilagiges Vorfabrikat wie in der Beschreibung gemäss den Figuren 1a bis le sowie den Figuren 2 und 3 dargelegt, verwendet. Die **Figuren 6a bis 6e** entspricht derjenigen der Figuren la bis le, sodass diese verwiesen und hier nicht wiederholt wird. Das Vorfabrikat dieses Verfahrenszustandes besteht aus Leitschichten 1,2,10,20 und einer Isolatorschicht 3 von 10 bis 50 µm Dicke. Die Öffnung 4* weist in dieser Ausführungsform eine kreisförmige Geometrie auf und hat kleine Durchmesser von 10 bis 100 µm. Der Mündungsbereich der Öffnung 4* weist aufgrund des beispielsweise verwendeten Plasma-Ätz-Prozesses eine grösseren Durchmesser als die Innenbereiche auf. Die Metallschichten sind durch die Isolatorschicht 3 voneinander getrennt.

Gemäss **Figur 6f** wird eine Schicht Photresist 11 in bekannten photochemischen Verfahren belichtet und ein Schaltungsentwurf 80 übertragen. Es kann festes oder flüssiges Photoresist verwendet werden. Das Photoresist kann die Öffnung 4* auch vollständig ausfüllen. Im Inneren der Öffnung 4* wird so ein Entwurf für ein Sackloch 80.3 mit Kontaktstelle und zuführendem Leiter in der Ebene der Schichten 1,2 oder XY-Leiter angelegt. Die Begrenzung des Entwurfes dieser Kontaktstelle liegt auf den schrägen Oberflächen der Öffnung 4*. Beidseitig des Kontaktstellentwurfes 80.3 verlaufen XY-Leiterentwürfe 80.1,80.2 direkt an der Öffnung. Verglichen mit der Ausführungsform gemäss Figur 1f verlaufen diese XY-Leiterentwürfe 80.1,80.2,80,3 in einem minimalen Sicherheitsabstand zueinander und nicht wie gemäss Figur 1f in einem minimalen Sicherheitsabstand zu einer Lötstellenumgrenzung. Die Abstände zwischen XY-Leiterentwürfen 80.1,80.2, 80.3 sind um die flächige Ausdehnung dieses Lötauges gemäss Figur 1f reduziert.

Gemäss **Figur 6g** werden unbelichtete Oberflächenbereiche Photoresist 11 bis auf die Metallschichten 10,20 herab entfernt. Gemäss dem Schaltungsentwurf 80 werden in einem Verfahrensschritt XY-Leiter, schräg oder senkrecht hierzu verlaufende Durchleitungsleiter oder Z-Leiter und eine Kontaktstelle vorgebildet. Gemäss **Figur 6h** wird in Oberflächenbereichen, die nicht mit strukturietem Photoresist 11 bedeckt sind, Metall der Leitschichten 1,2,10,20 bis auf die Isolatorschicht 30 herab, beispielsweise nasschemisch, weggeätzt. Das restliche Photoresist 11 wird daraufhin entfernt (siehe **Figur 6i**). Hierdurch werden XY-Leiter 14.1,14.2,14.3 und eine Durchleitung 14 in Form eines aufplattiertes Sackloch mit Kontaktstelle und Z-Leiter 14.4 eines Leiterbilds erzeugt. Die Durchplattierung wird als Durchleitung 14 bezeichnet.

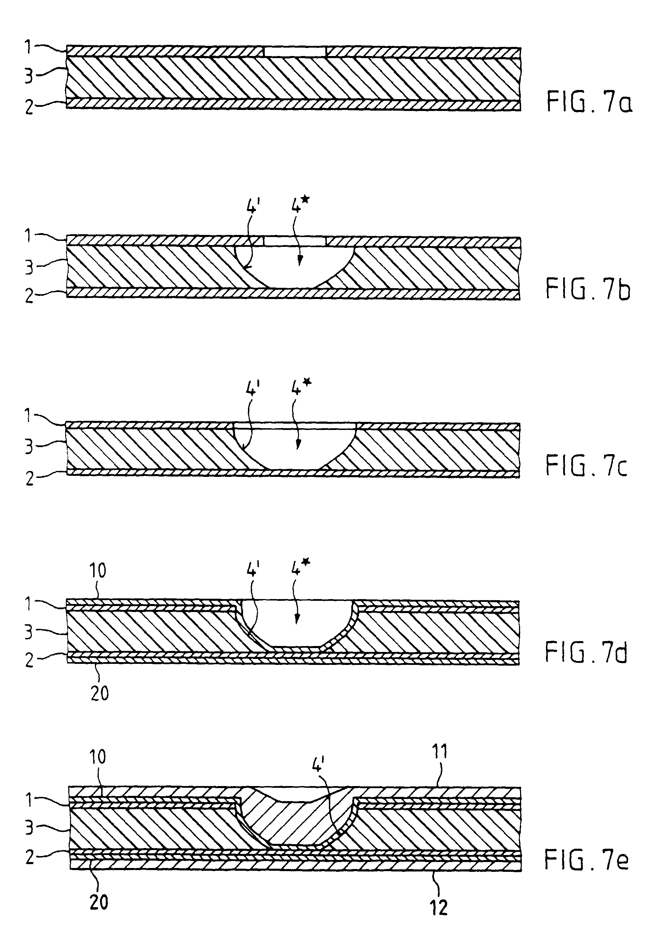

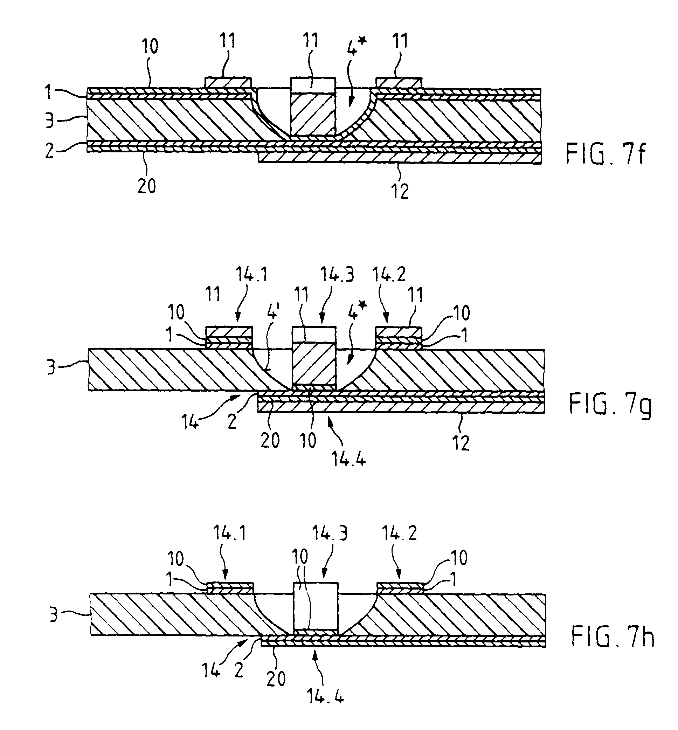

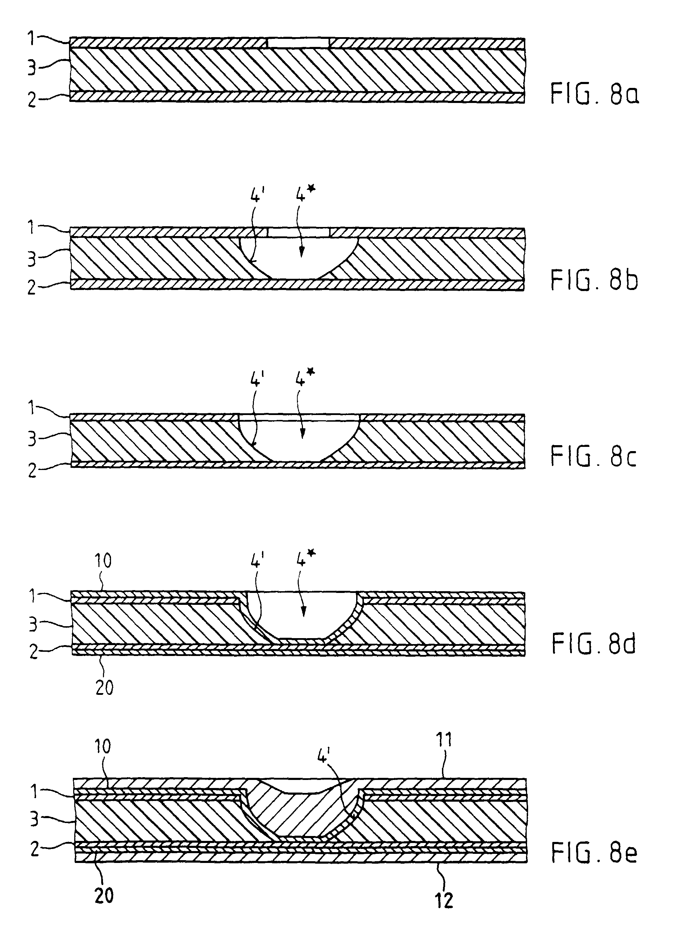

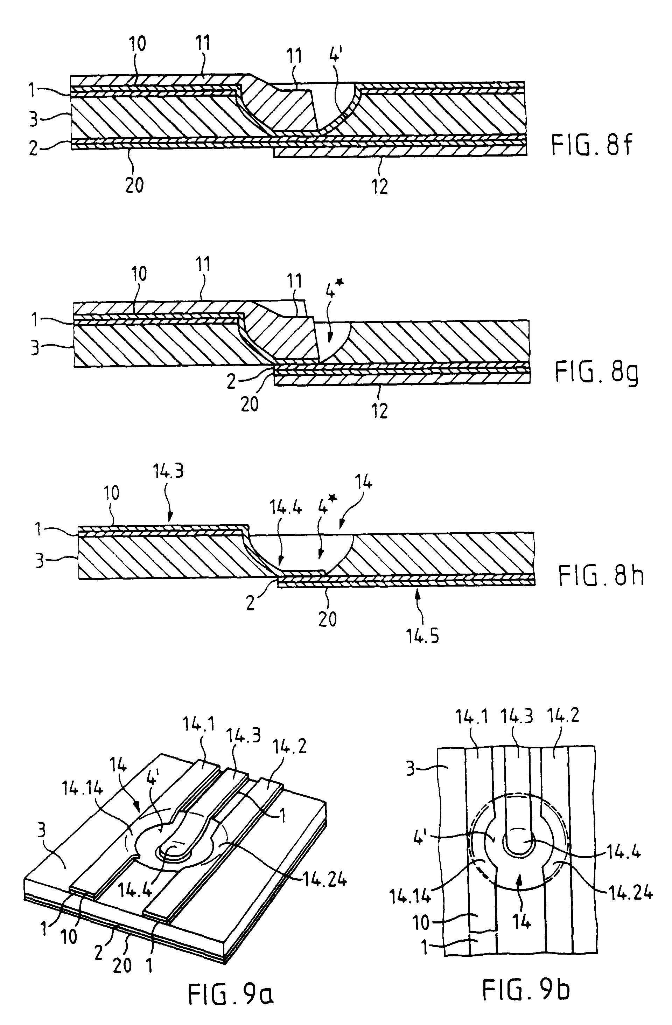

In dieser Ausführungsform werden drei parallel zueinander verlaufende XY-Leiter 14.1,14.2,14.3 an die Durchleitung 14 herangeführt, wovon der eine der XY-Leiter 14.3 an die Öffnung 4* herangeführt und in einen Z-Leiter 14.4 übergeht. Dieser Z-Leiter bildet teilweise die Kontaktstelle und verbindet die beiden elektrisch leitfähigen Ebenen 1 und 2 des Vorproduktes, d.h. er bildet eine elektrische Verbindung mit einen weiteren XY-Leiter 14.5 der Ebene 2 gemäss den Figuren 7h und 8h. Die Mündungen der Durchleitung 14 weist frei strukturierbare gerade oder runde Kanten auf. Sie ist leer oder mit einem elektrisch isolierendem Material gefüllt.

Die Durchleitung 14 ist in einer Öffnung 4* mit schrägen, sich zur Mündung erweiternden Wänden. Die Kontaktstelle liegt im Inneren der Öffnung 4*. Der minimal notwendige Abstand der elektrischen XY-Leiter 14.1,14.2,14.3 wird nicht mehr durch die flächige Ausdehnung einer Kontaktstelle limitiert. Die XY-Leiter 14.1,14.2,14.3 sind im gesamten Leiterplattenbereich minimal eng geführt, was eine optimale und dichteste Strompfadbelegung der Leiterplatten oder Folienleiterplatte darstellt. In dieser beispielhaften optimalen Realisierung eines Layoutes in einer optimalen elektrischen Schaltung, werden XY-Leiter beispielsweise 30 bis 50% enger verglichen mit der Realisierung gemäss Figur li geführt. Neben der optimalen Platzausnutzung und der optimalen Realisierung eines Layoutes stelle diese auch im Bereich von Kontaktstellen im konstanten Abstand zueinander geführten XY-Leiter optimale Leitergeometrie für hochfrequente Anwendungen dar, da unerwünschte Reflexionen und Signalstörungen vermieden werden.

Die **Figuren 7a bis 7h** sowie **8a bis 8h** zeigen in Querschnitten senkrecht und parallel zu den XY-Leiterzügen gemäss den Figuren 6a bis 6h ein erfindungsgemässens Verfahren zur Herstellung einer Durchleitung mit Kontaktstelle in Leiterplatten oder Folienleiterplatten in Form eines Sackloches. Die Beschreibung der Figuren 7a bis 7h sowie 8a bis 8h entspricht derjenigen der Figuren 6a bis 6i, sodass diese verwiesen und hier nicht wiederholt wird.

Im Unterschied zur Ansicht gemäss den Figuren 6a bis 6i ist in den Querschnitten gemäss den Figuren 7a bis 7h und 8a bis 8h auch die Strukturierung der weiteren Leitschicht 2 sowie der auf ihr aufplattierten Leitschicht 20 mittel Photoresistes 12. Diese Strukturierung eines beispielhaften XY-Leiters 14.5 verläuft gleichzeitig und analog zur Strukturierung der ersten Leitschicht 1 und der auf ihr aufplattierten Leitschicht 10 mittel Photoresists 11.

Die Figuren 7f und 8f zeigen die Strukturierung der Schicht Photoresist 11 auf schrägen Oberflächen der Öffnung 4*. Die strukturierte Schicht Photoresist 11 besteht aus frei wählbaren Z-Leiterstrukturen, welche bis auf die metallischen Schichten 10,20 herabreichen. In den Bereichen, wo sich Photoresist 11 befindet, wird in den folgenden Verfahrensschritten keine Leitmaterial entfernt.

Die Strukturierung der schrägen Oberfläche 4' zu einer Durchleitung 14 durch die Öffnung 4* ist nur aufgrund der gewählte Längenverhältnisse L=Dₘ/dₘ für die Dimensionen der Öffnung 4* und der Dicke der Leiterplatte oder Folienleiterplatte möglich. Mit Dₘ wird der minimaler Durchmesser der Öffnung 4* nach Auftragung der Schichten Metall 10 und Photoresisit 11 bezeichnet, mit dₘ wird die maximale Dicke der Leiterplatte oder Folienleiterplatte nach Auftragung der Schichten Metall 10 und Photoresist 11 bezeichnet. Die Z-Leiterstrukturen lassen sich also problemlos generieren, wenn der minimale Durchmesser Dₘ und die maximale Dicke dₘ einem günstigen Längenverhältnis L-1 und die gleiche Grössenordnung aufweisen. Dies hat Auswirkungen. Für dicke Leiterplatten muss der Durchmesser der Öffnungen 4* dementsprechend vergrössert werden. D.h. für eine 1 mm dicke Leiterplatte müssen die Öffnung 4* einen Durchmesser von 1 bis 2 mm aufweisen, um ein gleiches Längenverhältnis zu erhalten.

Diese erfindungsgemässe Durchleitung 14 ermöglicht in Analogie zur Beschreibung gemäss den Figuren 2 bis 5 eine nachträgliche Konditionierung der Schaltungen durch mechanisches Durchtrennen von an die Durchleitung 14 herangeführten XY-Leitern 14.1,14.2,14.3,14.5. So kann eine Universal-Leiterfolie mit mehreren möglichen Schaltungen strukturiert werden und je nach gewünschter Schaltung, kann am Ende des Herstellungsverfahrens eine dieser Schaltungen in einer Konditionierung realisiert werden. Diese Konditionierung kann auch durch photochemisches Entfernen von XY-Leitern 14.1,4.2,14.3,14.5 und/oder von Z-Leitern 14.4 geschehen.

Die **Figuren 9a und 9b** zeigen eine perspektivische Ansicht und eine Draufsicht einer weiteren im erfindungsgemässen Verfahren hergestellten Durchleitung in der Ausführungsform eines Sackloches mit Kontaktstelle. Diese Ausführungsform ähnelt weitgehend der in den Figuren 6a bis 6i gezeigten Ausführungsform, sodass die Schritte des Herstellungsverfahrens hier nicht wiederholt werden. Im Unterschied zu dieser Ausführungsform gemäss Figur 6i werden drei parallel zueinander verlaufende XY-Leiter 14.1,14.2,14.3 an die Durchleitung 14 herangeführt und sie werden in die Öffnung 4* hineingeführt. Ein XY-Leiter 14.3 geht in einen Z-Leiter 14.4 über, der teilweise die Kontaktstelle bildet und die beiden elektrisch leitfähigen Ebenen 1 und 2 des Vorproduktes elektrisch verbindet, dies ist gemäss den Figuren 7h und 8h gezeigt. Im Unterschied hierzu werden XY-Leiter 14.1,14.2 über die schrägen, sich zur Mündung erweiternden Wände der Öffnung 4* hinweg geführt, sie senken sich in die schräge Oberfläche 4' der Öffnung 4* hinein, verlaufen durch diese hindurch, um wieder auf der YX-Fläche ihren weiteren Verlauf zu nehmen. Auf diese Weise ist es möglich, dass diese im äquidistanten Abstand zum Z-Leiter 14.4 in der Öffnung verlaufen bzw. wieder aus der Öffnung 4* hinausgeführt, auf der gleichen Ebene Leitschicht 1 wieder zu den XY-Leitern 14.1,14.2 weiterzulaufen. Der minimal notwendige Abstand der elektrischen XY-Leiter 14.1,14.2,14.3 wird nicht mehr durch die flächige Ausdehnung des Sackloches limitiert. XY-Leiter lassen sich sehr wohl in Öffnungen 4* hineinführen. Der Kegelrand des Sackloches kann also zum Verlegen von XY-Leitern verwendet werden, die nicht mit Leitern einer anderen Ebene Leitschicht 2 einen elektrischen Kontakt bilden. Die XY-Leiter 14.1,14.2,14.3 sind somit im gesamten Leiterplattenbereich minimal eng geführt, was eine optimale und dichteste Strompfadbelegung der Leiterplatten oder Folienleiterplatte darstellt. In dieser beispielhaften optimalen Realisierung eines Layoutes in einer optimalen elektrischen Schaltung, werden XY-Leiter beispielsweise 30 bis 50% enger verglichen mit der Realisierung gemäss Figur li geführt, und dies obwohl das Sackloch den ungefähren Durchmesser des Lötauges 1 gemäss Figur 1i aufweist. Neben der optimalen Platzausnutzung und der optimalen Realisierung eines Layoutes stelle diese auch im Bereich von Kontaktstellen im konstanten Abstand zueinander geführten XY-Leiter optimale Leitergeometrie für hochfrequente Anwendungen dar, da unerwünschte Reflexionen und Signalstörungen vermieden werden.

## Patentansprüche

1. Mehrlagige Leiterplatten oder Folienleiterplatten, mit in elektrisch leitenden Schichten (1,2,10,20) strukturierten Leitern (XY-Leitern 4.1,4.2,14.1,14.2,14.3,14.5), mit Durchleitungen (4,14) von Leitschicht (1) zu Leitschicht (2) durch Öffnungen (4*) in intermediären Isolatorschichten (3), **dadurch gekennzeichnet**, dass eine Durchleitung (4,14) auch innerhalb der Öffnung (4*) strukturiert ist und dadurch einen oder mehrere Durchleitungsleiter (Z-Leiter 4.4,14.4, 14,14,14,24) in der Öffnung (4*) der Isolatorschicht (3) aufweist, sodass in einer Durchleitung (4,14) einer oder mehrere Durchleitungsleiter (Z-Leiter 4.4,14.4,14.14,14.24) beschaltbar sind.

2. Mehrlagige Leiterplatten oder Folienleiterplatten gemäss Anspruch 1, **dadurch gekennzeichnet**, dass mindestens ein Leiter (14.3) einer strukturierten Leitschicht (1,10) an eine Durchleitung (14) mündet, dass der mindestens eine Leiter (14.3) über mindestens einen Durchleitungsleiter (14.4) der strukturierten Leitschicht (10) mit mindestens einem Leiter (14.5) einer weiteren strukturierten Leitschicht (2,20) elektrisch verbunden ist.

3. Mehrlagige Leiterplatten oder Folienleiterplatten gemäss Anspruch 1, **dadurch gekennzeichnet**, dass mindestens zwei gegeneinander elektrisch isolierte Leiter (4.1) einer strukturierten Leitschicht (1,10) an Durchleitungen (4) münden, dass die Leiter (4.1) über Durchleitungsleiter (4.4) in einer strukturierten Leitschicht (10) mit mindestens zwei gegeneinander elektrisch isolierten Leitern (4.2) einer weiteren strukturierten Leitschicht (2,20) elektrisch verbunden sind.

4. Mehrlagige Leiterplatten oder Folienleiterplatten gemäss Anspruch 2 oder 3, **dadurch gekennzeichnet**, dass Mündungen (4.1m,4.2m) der Durchleitungen (4,14) frei strukturierte, gerade oder runde Kanten aufweisen.

5. Mehrlagige Leiterplatten oder Folienleiterplatten gemäss Anspruch 2 oder 3, **dadurch gekennzeichnet**, dass die Durchleitungen (4,14) leer sind oder mit einem elektrisch isolierendem Material gefüllt sind.

6. Mehrlagige Leiterplatten oder Folienleiterplatten gemäss Anspruch 2 oder 3, **dadurch gekennzeichnet**, dass die Durchleitungen (4,14) schräge oder senkrechte Oberflächen (4') aufweisen und dass sich die die Öffnungen (4*) konisch oder kugelförmig ins Innere der Isolatorschicht (3) erstecken.

7. Mehrlagige Leiterplatten oder Folienleiterplatten gemäss Anspruch 2, **dadurch gekennzeichnet**, dass die Öffnung (4*) in Form eines Sackloches gearbeitet ist, dass die Durchleitung (14) eine Kontaktstelle für zu bestückende Bauelemente ist, die vollständig im Inneren der Öffnung (4*) der Durchleitung (14) liegt und durch die Mündung der Öffnung (4*) begrenzt ist, sodass der minimale Abstand zwischen Leiter (14.1,14.2,14.3) durch diese Kontaktstelle unbeeinträchtigt ist und ein dichtestmögliches Leiterbild realisierbar ist.

8. Mehrlagige Leiterplatten oder Folienleiterplatten gemäss Anspruch 3, **dadurch gekennzeichnet**, dass die Öffnung (4*) in Form eines Durchgangsloches gearbeitet ist, dass die Durchleitung (4) mehrere Durchleitungsleiter (4.5) aufweist und ein dichtestmögliches Leiterbild realisierbar ist.

9. Mehrlagige Leiterplatten oder Folienleiterplatten gemäss Anspruch 2, **dadurch gekennzeichnet**, dass die Öffnung (4*) in Form eines Sackloches mit schrägen Oberflächen (4') gearbeitet ist, dass die Durchleitung (14) eine Kontaktstelle für zu bestückende Bauelemente ist, die vollständig im Inneren der Öffnung (4*) der Durchleitung (14) liegt und durch die Mündung der Öffnung (4*) begrenzt ist, dass mindestens ein Leiter (14.1,14.2) in diese Öffnung (4*) hineingeführt werden, auf schrägen Oberflächen (4') der Öffnung (4*) verläuft und dass der mindestens eine Leiter (14.1,14.2) über mindestens einen Durchleitungsleiter (14,14,14,24) der strukturierten Leitschicht (10) mit mindestens einem Leiter (14.1,14.2) der gleichen strukturierten Leitschicht (1,10) elektrisch verbunden ist, sodass der minimale Abstand zwischen Leiter (14.1,14.2,14.3) durch diese Kontaktstelle unbeeinträchtigt ist und ein dichtestmögliches Leiterbild realisierbar ist.

10. Verfahren zum Herstellen mehrlagiger Leiterplatten oder Folienleiterplatten, mit in elektrisch leitenden Schichten (1,2,10,20) strukturierten Leitern (XY-Leiter 4.1,4.2,14.1,14.2,14.3,14.5), mit Durchleitungen (4,14) von Leitschichten (1) zu Leitschichten (2) durch intermediäre Isolatorschichten (3), wobei durch photochemische Strukturierung im Inneren der öffnungen (4*) in Isolatorschichten (3) Durchleitungen (4,14) mit mindestens einem Durchleitungsleiter (Z-Leiter 4.4,14.4) zur Verbindung von einem oder mehreren Leitern (XY-Leiter 4.1,4.2,14.1,14.2,14.5) verschiedener Leitschichten (1,2) gebildet werden.

11. Verfahren gemäss Anspruch 10, **dadurch gekennzeichnet**, dass Öffnungen in Leitschichten (1,2) geätzt werden, dass in gemss diesen Öffnungen in Leitschichten (1,2) Öffnungen in Isolatorschichten (3) geätzt werden, dass Leitschichtenbereich an den Rändern dieser Öffnungen unterätzt werden, dass diese unterätzten Leitschichtenbereiche weggeätzt werden, sodass Öffnungen (4*) mit schrägen Oberflächen (4') gebildet werden, die sich konisch oder kugelförmig ins Innere der Isolatorschicht (3) erstecken.

12. Verfahren gemäss Anspruch 11, **dadurch gekennzeichnet**, dass die Öffnungen (4*) in Form von Durchgangslöchern mit zwei Lochöffnungen ausgebildet werden und dass die Lochöffnungen in Achse oder axial versetzt zueinander angebracht werden.

13. Verfahren gemäss einem der Ansprüche 10 bis 12, **dadurch gekennzeichnet**, dass Öffnungen (4*) und Leitschichten (1,2) mit Leitschichten (10,20) aufplattiert werden, dass die Leitschichten (1,2,10,20) in einem Verfahrensschritt gleichzeitig photochemisch in Leiter (4.1,4.2,14.1,14.2,14.3,14.5) und Durchleitungsleiter (4.4,14.4,14.14,14.24) strukturiert werden.

14. Verfahren gemäss Anspruch 10, **dadurch gekennzeichnet**, dass durch mechanisches Durchtrennen von an die Durchleitungen (4,14) herangeführten Leitern (4.1,4.2,14.1,14.2,14.3,14.5) eine nachträgliche Konditionierung der Durchleitungen (4,14) erfolgen kann.

15. Verfahren gemäss Anspruch 10, **dadurch gekennzeichnet**, dass durch photochemisches Entfernen von an Durchleitungen (4,14) herangeführten Leitern (4.1,4.2,14.1,14.2,14.3,14,5) eine nachträgliche Konditionierung der Durchleitungen (4,14) erfolgen kann.

16. Vorfabrikat zur Weiterverarbeitung gemäss dem Verfahren nach Anspruch 10, **dadurch gekennzeichnet**, dass Öffnungen (4*) mit minimalen Durchmessern (Dₘ) gearbeitet werden und dass Leiterplatten oder Folienleiterplatten von maximalen Dicken (dₘ) verwendet werden, derart, dass die minimalen Durchmesser (Dₘ) zu den maximalen Dicken (dₘ) ein günstiges Längenverhältnis (L=Dₘ/dₘ)∼1 für die Strukturierung von Durchleitungen (4,14) aufweisen.

17. Vorfabrikat zur Weiterverarbeitung gemäss dem Verfahren nach Anspruch 10, **dadurch gekennzeichnet**, dass Mündungen (4.1m,4.2m) der Öffnungen (4*) frei strukturierbar mit geraden Kanten und mindestens drei Ecken oder frei strukturierbar mit runden Kanten gearbeitet werden.

18. Vorfabrikat zur Weiterverarbeitung gemäss dem Verfahren nach Anspruch 10, **dadurch gekennzeichnet**, dass Öffnungen (4*) schräge senkrechte Oberflächen (4') aufweisen und dass sich die die Öffnungen (4*) konisch oder kugelförmig ins Innere der Isolatorschicht (3) erstecken.
